# EUROPEAN PATENT APPLICATION

(11) **EP 1 998 371 A1**
(43) Date of publication of application: **03.12.2008**
(21) Application number: 07109351.2
(22) Date of filing: 31.05.2007
(51) Int. Cl.: H01L 23/498

(54) **Method of manufacturing electrical conductors for a semiconductor device**

(71) Applicant: Infineon Technologies SensoNor AS, 3192 Horten (NO)
(72) Inventor: Skog, Terje, 3180, Nykirke (NO); Nilsen, Svein Møller, 3080, Holmestrand (NO)
(74) Representative: Haley, Stephen

(57) **Abstract**

A method of manufacturing an electrical conductor for a semiconductor device having one or more layers comprises etching from a first surface (2a) to a second surface (2b) of at least one layer of the device to form a channel (1) having a wall extending from the first surface to the second surface. The channel defines a gap extending from the first surface to the second surface. An insulating layer (6) is provided on the channel wall. Conductive material is patterned on the channel wall to form multiple separate electrical conductors (3), which are insulated from material of the at least one layer by the insulating layer, thereon, such that the gap that extends from the first surface to the second surface is maintained. A corresponding semiconductor device is also provided.

## Description

The present invention relates to a method of manufacturing electrical conductors for a semiconductor device.

Various methods are known in which electrical elements are provided between two sides of a wafer, for example a semiconductor wafer, in order to allow electrical connection between the layers of a device or to external components connected to the device.

Known techniques involve either patterning edges of a semiconductor wafer after dicing or creating vias or channels through a layer of semiconductor material semiconductor wafer and filling the vias with electrically conductive material, each via providing a single electrical contact.

However, there are many disadvantages associated with the known techniques. Patterning after dicing is expensive in high volumes, while creating vias and filling them with conductive material is increasingly technically difficult with thicker semiconductor wafers. A separate via is required for each contact, while the vias make the wafers and any semiconductor products or systems comprising such wafers more fragile. The thermal expansion of the conductive material is often mismatched compared to that of the semiconductor wafer, and hence the conductive material induces stress in the semiconductor wafer.

The present invention provides a method of manufacturing an electrical conductor for a semiconductor device, the device having one or more layers, the method comprising the steps of:
etching from a first surface to a second surface of at least one layer of the device to form a channel having a wall extending from the first surface to the second surface, said channel defining a gap extending from the first surface to the second surface;
providing an insulating layer on said channel wall; and
patterning conductive material on said channel wall to form multiple separate electrical conductors, which are insulated from material of the at least one layer by the insulating layer, thereon, such that the gap that extends from the first surface to the second surface is maintained.

The invention further provides a semiconductor device comprising one or more layers, at least one layer comprising:
a channel having a wall extending from the first surface to the second surface, said channel defining a gap extending from the first surface to the second surface;
an insulating layer provided on said channel wall; and
multiple electrical conductors patterned on the channel wall, the electrical conductors being insulated from material of the at least one layer by the insulating layer, such that the gap that extends from the first surface to the second surface is maintained.

The invention seeks to solve the above problems by making vertical conductors through one or more deep etched channels or openings in a wafer or layer of a semiconductor device, which allow electrical interconnection between two sides of the semiconductor wafer or layer. Each channel defines a gap that extends between the surfaces of the two sides of the semiconductor wafer. An electrical conductor is then formed on a wall of the channel by patterning conductive material on an insulating layer, while the gap between the semiconductor wafer or layer surfaces is maintained. Such a gap is advantageous as it effectively acts as a buffer, allowing for a difference in the thermal expansion properties of the semiconductor, insulator and conductor materials. There is therefore no weakening or distortion of the semiconductor wafer or the overall device when a change in temperature occurs. Additionally, each channel is wide enough to simplify the plating process and thus provide multiple conductors through the channels.

The channels are preferably placed along the sawing lines of the semiconductor wafer. In this way the conductors can occupy a minimum of the active wafer area, without weakening the die.

Examples of the present invention will now be described with reference to the accompanying drawings, in which:
Figure 1 shows a plan view of a semiconductor wafer upon which the method of the present invention has been performed;
Figures 2 to 7 show perspective views of a portion of the semiconductor wafer during each step of the manufacturing method of the present invention;
Figure 8 shows a detailed plan view of a channel of the wafer in which multiple conductors are plated thickly enough to extend into a sawing gate of the wafer;
Figure 9 shows how wafers formed according to the invention are edge-mounted;
Figure 10 shows how wafers formed according to the invention are vertically stacked; and
Figure 11 shows an example of the bottom surface or rearside of a wafer formed according to the invention, onto which conductive pads have been patterned.

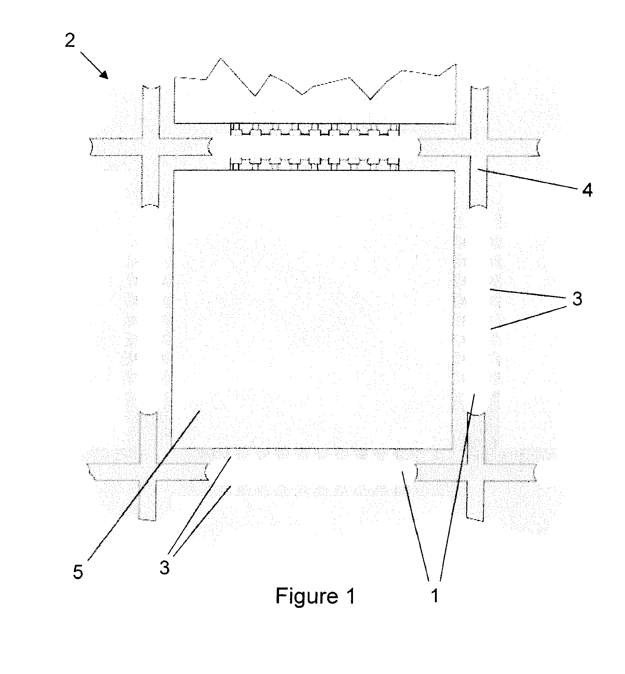

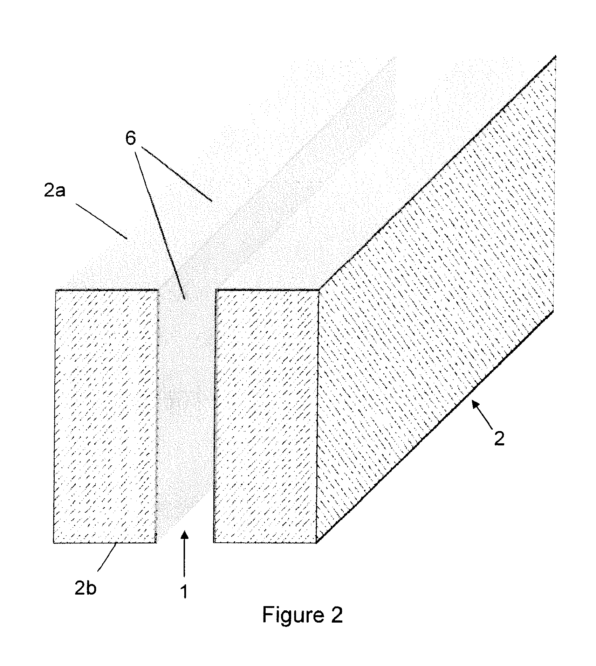

Referring to an embodiment of the invention shown in figure 1, one or more channels or openings 1 are created between two surfaces 2a and 2b (not shown, see figure 2) of a semiconductor wafer or layer 2, and multiple electrically conductive elements 3 are provided between the surfaces 2a and 2b to allow for electrical connection therebetween. A gap between the semiconductor wafer or layer surfaces is maintained. Such a gap is advantageous as it allows for a difference in the thermal expansion properties of the semiconductor, insulator and conductor materials. There is therefore no weakening or distortion of the semiconductor wafer or the overall device when a change in temperature occurs.

The channels 1 are preferably placed along the sawing gates 4 of the semiconductor wafer 2 as shown in figure 1. In this way, openings that are large enough to simplify the processes needed to make vertical conductors 3 between layers of a semiconductor device incorporating the semiconductor wafer 2 are achieved. A minimum of the active area 5 is then disturbed by vias. Therefore, the conductive elements 3 occupy a minimum of the active area 5 of the semiconductor wafer 2, without weakening the wafer or die.

The manufacturing process involves patterning, performing deep etch resist techniques and plating with conductive material, as described further below.

As shown in figure 2, a deep channel or opening 1 is etched in a semiconductor wafer 2 and is insulated by, for example, growing an oxide layer 6 where required on the surface(s) of the semiconductor wafer 2, and in particular on the wafer surfaces of the channel wall.

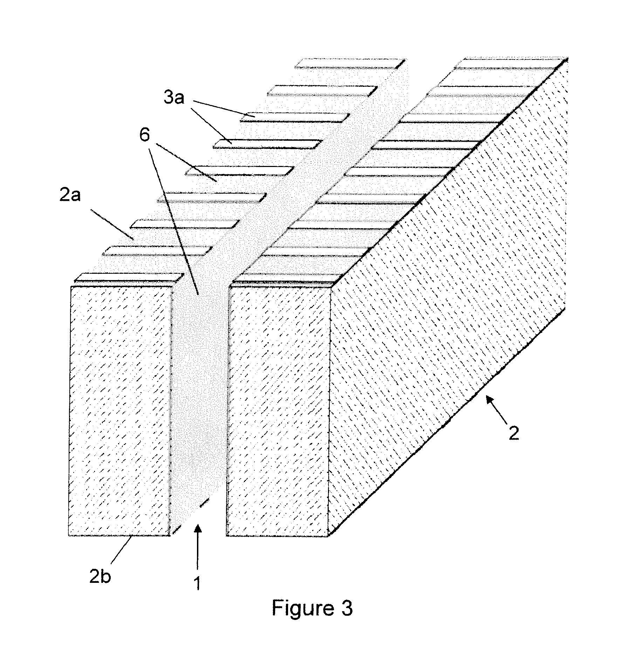

Referring to figure 3, conductive traces 3a are then patterned on the oxide layer 6 and are provided up to the edge of the deep etched channel or opening 1 on both sides of the semiconductor wafer 2.

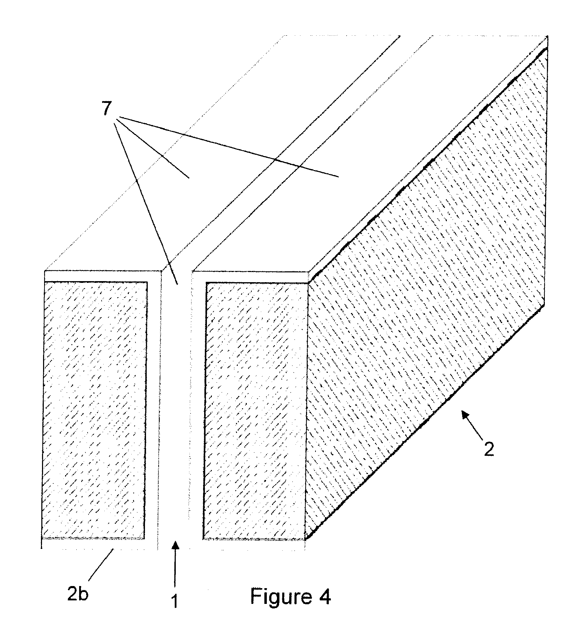

Referring to figure 4, both surfaces 2a, 2b of the semiconductor wafer 2 including the surfaces of the channel 1 are covered with a polymer layer 7. It is also possible to completely fill the channel 1 with polymer material to make subsequent patterning easier.

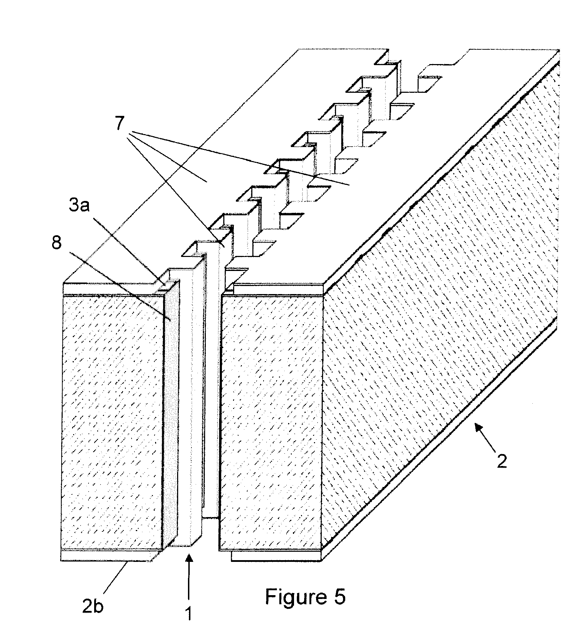

Referring to figure 5, the polymer layer 7 is masked and patterned on the semiconductor wafer surfaces formed by the channel, and preferably on both surfaces 2a, 2b of the wafer 2. Then the polymer 7 is deep etched to bare vertical (with reference to the figures) areas or recesses 8 of the channel walls and also to reveal the ends of the top conductive traces 3a. One of the sides (top/front side 2a or bottom/rear side 2b) may be wet etched to reveal the ends of the conductive traces 3a.

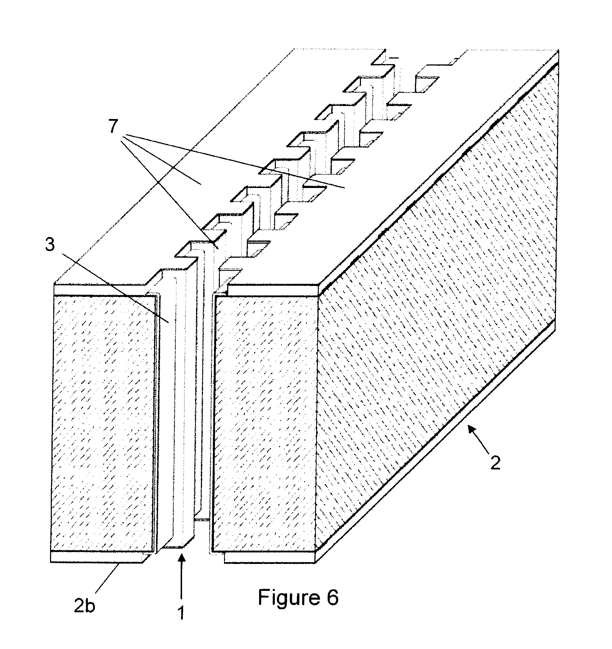

The open surface has then been prepared for plating. Referring to figure 6, the vertical areas or recesses 8 of the channel wall are plated with conductive material to the required or preferred material thickness.

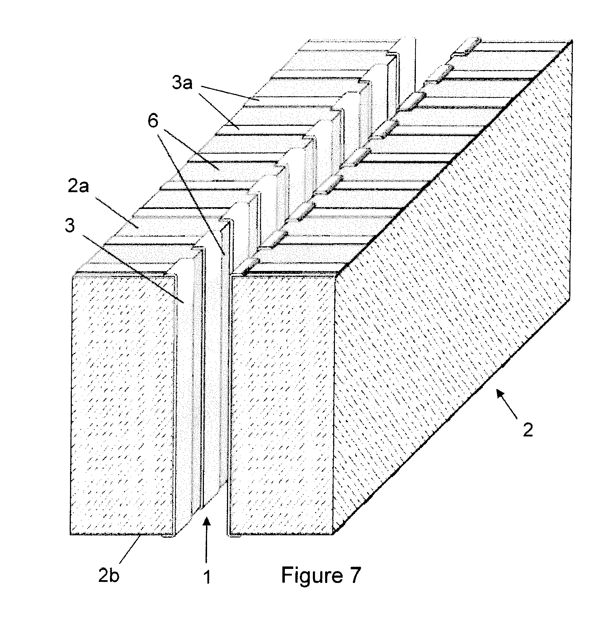

Referring to figure 7, the mask and the polymer layer 7 are removed. The channel or opening 1 in the semiconductor wafer 2 now has vertical conductors 3 that are connected at both ends.

As an alternative example of the method of the present invention, instead of connecting both semiconductor wafer surfaces 2a, 2b at once, it is possible to use a handling wafer on the reverse side during the same processes as above. Then remove the handling wafer and process the reverse side to produce conductors 3a out and onto the ends of the vertical conductors 3 which are made up to a suitable thickness.

It is also possible to use the above methods to manufacture semiconductor wafers having blind channels for connection between layers of a semiconductor device having multiple layers.

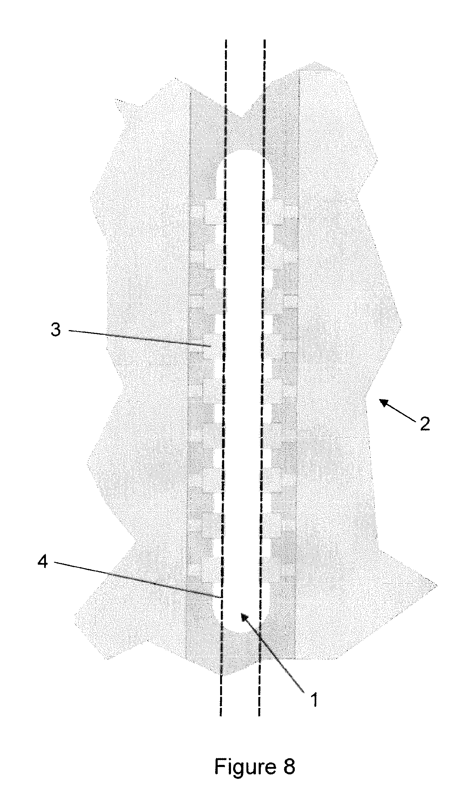

Figure 8 shows a detailed plan view of the channel 1 in which the conductors 3 are plated thickly enough to extend into one of the dicing or sawing gates 4. Therefore, when the wafer or chip 2 has been sawn (along the dashed lines of Figure 8), the conductors 3 each have a surface that is flush with the rest of the edge of the wafer or chip 2. This makes allows separate chips 2 to be connected together by edge-mounting.

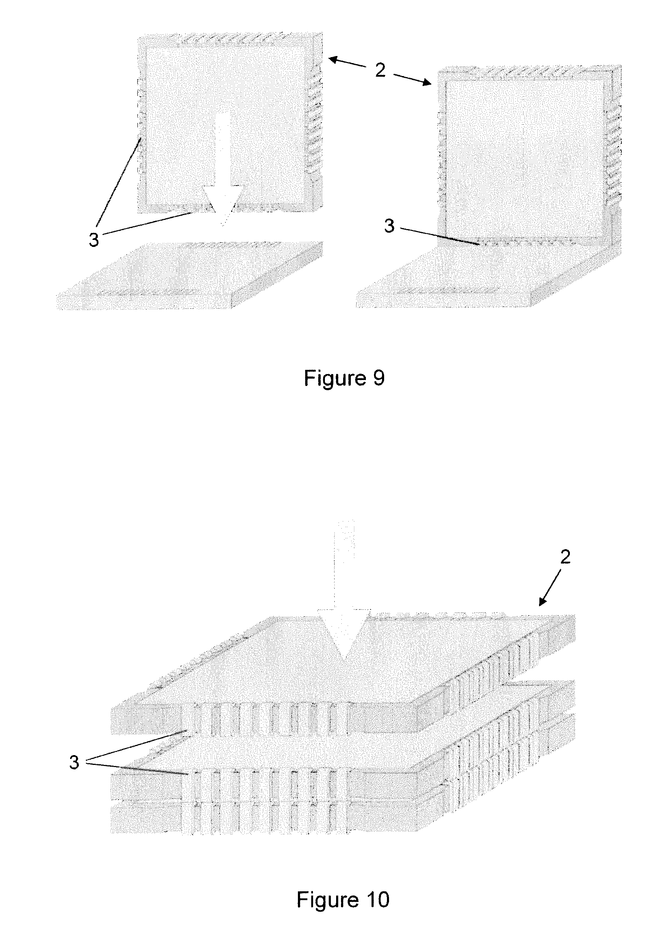

Figure 9 shows an example of such edge-mounting, which allows the manufacture of MEMS units or devices having a specified direction of sensitivity, and can additionally be used to assemble functional units with several directions of sensitivity. Edge-mounting is also advantageous in assembling several heterogeneous chips, for example where ordinary stacking is likely to interfere with signal paths. Such an assembly technique also allows improved direct air cooling of chips compared with a conventional stacking technique, as the chips 2 are evenly and securely spaced apart without sacrificing the reliability of the electrical connection between the conductors 3.

In a preferred embodiment, the end connectors 3 are made thick enough to serve as direct interconnects in a stacked configuration with several dies, as shown in Figure 10 where a number of wafers or layers 2 are vertically stacked.

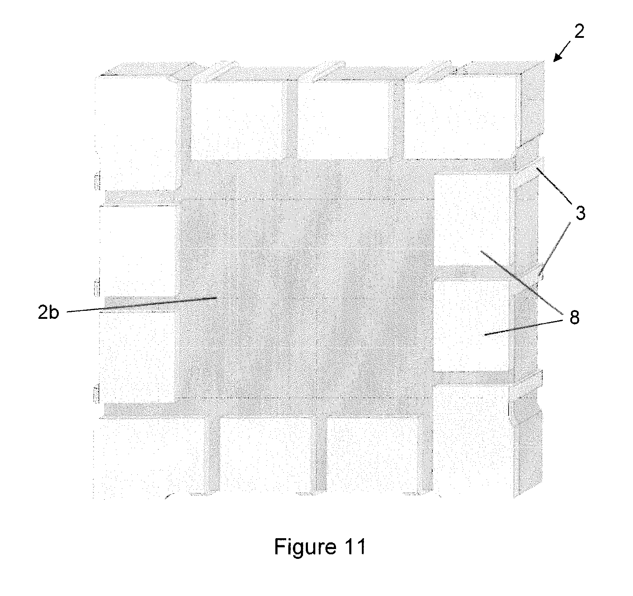

Figure 11 shows an example of the bottom surface or rearside 2b of the wafer 2, onto which conductive pads 8 have been plated or otherwise patterned. The pads 8 are preferably be patterned to the rearside 2b in the same step as patterning the vertical conductors 3. Such pads 8 aid electrical connection when directly mounting the rearside 2b of a diced (sawn) chip on a printed circuit board, or when attaching a wafer or a diced chip to further layers, wafers or components of the device.

## Claims

1. A method of manufacturing an electrical conductor for a semiconductor device, the device having one or more layers, the method comprising the steps of:
etching from a first surface to a second surface of at least one layer of the device to form a channel having a wall extending from the first surface to the second surface, said channel defining a gap extending from the first surface to the second surface;
providing an insulating layer on said channel wall; and
patterning conductive material on said channel wall to form multiple separate electrical conductors, which are insulated from material of the at least one layer by the insulating layer, thereon, such that the gap that extends from the first surface to the second surface is maintained.

2. The method according to claim 1, wherein the step of providing an insulating layer comprises growing an oxide layer.

3. The method according to any preceding claim, the method further comprising the step of:
patterning multiple conductive elements on at least one of the first and second surfaces, wherein the multiple conductive elements are positioned to allow connection to the multiple electrical conductors provided in the channel.

4. The method according to any preceding claim, the method further comprising the steps of:
providing a layer of polymer material on the channel wall;
masking the polymer layer; and
patterning the polymer layer to form multiple recesses in the channel wall.

5. The method according to claim 4, the method further comprising the steps of:
providing the layer of polymer material on at least one of the first and second surfaces; and
etching the polymer layer such that multiple conductive elements patterned on at least one of the first and second surfaces are at least partially exposed.

6. The method according to claim 4 or 5, wherein the conductive material is patterned such that the multiple electrical conductors are provided in the recesses formed in the channel wall.

7. The method according to any preceding claim, wherein the channel is open at one end thereof.

8. The method according to any preceding claim, wherein the channel is open at both ends.

9. The method according to any preceding claim, wherein the channel is formed in a sawn recess of the layer.

10. The method according to claim 9, wherein the electrical conductors extend into the channel such that, upon sawing the recess, the sawn surfaces of the conductors and the layer are flush with one another.

11. The method according to any preceding claim, the method further comprising the step of connecting an edge surface of a first layer to a surface of a second layer.

12. The method according to any preceding claim, wherein the ends of the conductors extend beyond at least one of the first and second surfaces of a first layer, such that when a second layer is connected to the conductors of said surface of the first layer, a space is maintained between the first and second layers.

13. The method according to any preceding claim, the method further comprising the step of providing electrically conductive pads on at least one of the first and second surfaces.

14. A semiconductor device comprising one or more layers, at least one layer comprising:
a channel having a wall extending from the first surface to the second surface, said channel defining a gap extending from the first surface to the second surface;
an insulating layer provided on said channel wall; and
multiple electrical conductors patterned on the channel wall, the electrical conductors being insulated from material of the at least one layer by the insulating layer, such that the gap that extends from the first surface to the second surface is maintained.
